Europäisches Patentamt

European Patent Office

Office européen des brevets

(19)

(11) Publication number: **0 107 355**
**A2**

# EUROPEAN PATENT APPLICATION

(21) Application number: **83305677.3**

(22) Date of filing: **23.09.83**

(51) Int. Cl.³: **G 11 C 8/00**

(30) Priority: **28.09.82  JP 167511/83**

(43) Date of publication of application: **02.05.84**
**Bulletin 84/18**

(84) Designated Contracting States: **DE FR GB**

(71) Applicant: **FUJITSU LIMITED, 1015, Kamikodanaka Nakahara-ku, Kawasaki-shi Kanagawa 211 (JP)**

(72) Inventor: **Aoyama, Keizo, 1-11-28, Tsukimino Yamato-shi, Kanagawa 242 (JP)**
Inventor: **Yamauchi, Takahiko,**
**Iseya-so 2F-1, 49 Kitaya-cho Nakahara-ku, Kawasaki-shi Kanagawa 211 (JP)**
Inventor: **Seki, Teruo,**
**Dai-2 Yayoi-so 5, 3-5-2 Shimo-shinjo Nakahara-ku, Kawasaki-shi Kanagawa 211 (JP)**

(74) Representative: **Skone James, Robert Edmund et al, GILL JENNINGS & EVERY 53-64 Chancery Lane, London WC2A 1HN (GB)**

(54) **CMIS circuit device.**

(57) A CMIS circuit device such as an IC chip of a semiconductor memory device which is made selectable by using at least two chip-select signals ($\overline{CS}_1$, $CS_2$) having opposite polarities. The CMIS circuit device has a chip-select control circuit for establishing a chip-selected state and a chip-unselected state upon receiving the above-mentioned chip-select signals. The chip-select control circuit comprises a CMIS inverter means ($IV_1$) for inverting one of the chip-select signals ($CS_2$) and a CMIS logic gate means ($IV_2$) for receiving an output signal (a) of the CMIS) inverter means and the other chip select signal or signals ($\overline{CS}_1$) and for outputting an internal chip-select control signal (CS). The CMIS inverter means ($IV_1$) comprises a CMIS inverter ($Q_{20}$, $Q_{21}$) and one or more control transistors ($Q_{19}$) which receive the other chip-select signal or signals ($\overline{CS}_1$) at the gates thereof and which are inserted in series between a power terminal of the CMIS inverter and a power source.

0107355

FUJITSU LIMITED          - 1 -        52/2150/02

<u>CMIS CIRCUIT DEVICE</u>

The present invention relates to a complementary metal-insulator semiconductor (CMIS) circuit device and in particular to a CMIS circuit device wherein an integrated circuit (IC) chip thereof can be selected by input signals at least two of which have opposite polarities.

In many cases, a plurality of IC chips of semiconductor memories and so on are used in one system, such as a computer, for the purpose of increasing the memory capacity. In such a system, a desired IC chip is selected from a plurality of IC chips for data reading or writing by a chip-select signal. In this case, it is desirable to cause IC chips not selected by a chip-select signal, i.e. unselected chips, to assume a battery backup condition, in which no current flows from the power source.

In a conventional CMIS circuit device, it is possible to select an IC chip thereof and to cause the circuit device to assume a battery backup condition by using one chip-select signal or by using two chip-select signals having the same polarity.

There is also known a CMIS circuit device in which an IC chip thereof is selected by using two chip-select signals having opposite polarities.

However, in the latter conventional CMIS circuit device, it is impossible to select an IC chip thereof by independently using both of the two chip-select signals having opposite polarities.

In accordance with the present invention, a CMIS circuit device the state of which is controlled by at least two input signals and which is made selectable on receiving input signals at least two of which have opposite polarities has a chip-select control circuit for establishing a chip-selected state and a chip-unselected state in accordance with the received input signals, the chip-select control circuit comprising CMIS inverter means for inverting one of the input signals and CMIS logic gate means for receiving an output signal of the CMIS inverter means and the other input signal or signals and for outputting an internal chip-select control signal, wherein the CMIS inverter means comprises a CMIS inverter and one or more control transistors receiving the other input signal or signals at the gates thereof and which are inserted in series between a power terminal of the CMIS inverter and a power source.

The present invention utilizes the concept of inserting one or more series-connected transistors between a power terminal of a first inverter, which inverts one input or chip-select signal, and a power source and of controlling each series-connected transistor with another input or chip-select signal.

One advantage of the present invention is to make it possible in a CMIS circuit device to obtain a condition in which a circuit current does not flow
at all and to realize a complete battery backup
condition when an IC chip is caused to assume an
unselected state by making at least one of two chip
select signals having opposite polarities approximately
equal to the power supply voltage or the ground
voltage.

Somes examples of devices in accordance
with the present invention will now be described
and contrasted with prior art devices with reference
to the accompanying drawings, in which:-

Figure 1 is an electrical circuit diagram
of a typical CMIS inverter;

Figure 2 is a graph illustrating the
voltage-current characteristics of the circuit of
Figure 1;

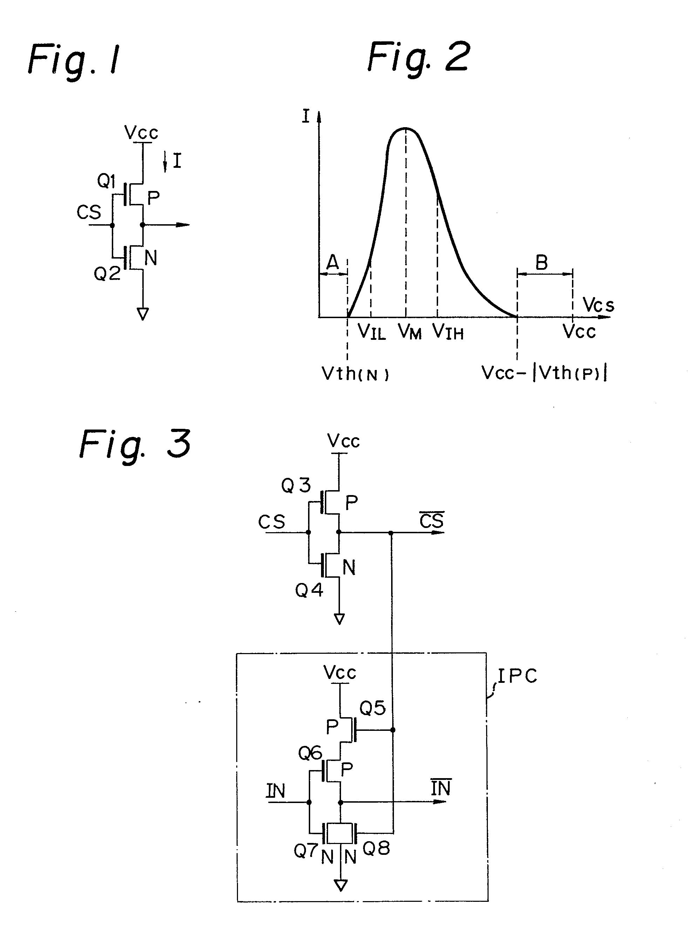

Figures 3 to 6 are partial electrical circuit
diagrams illustrating conventional CMIS circuit
devices;

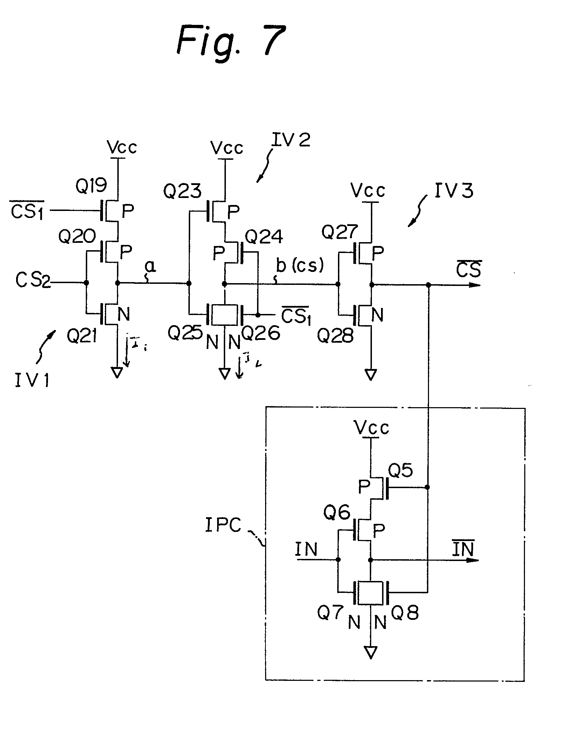

Figure 7 is a partial electrical circuit diagram illustrating the configuration of an embodiment of a CMIS circuit device according to the present invention;

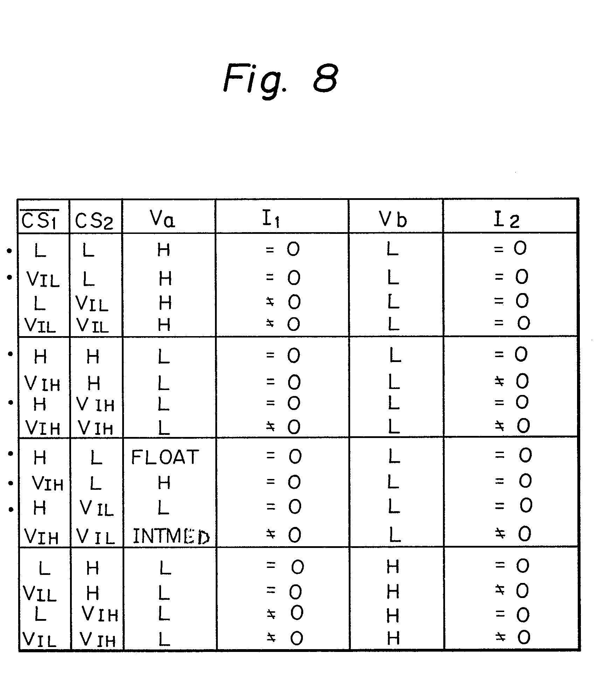

Figure 8 is a table illustrating the operation of the circuit of Fig. 7; and

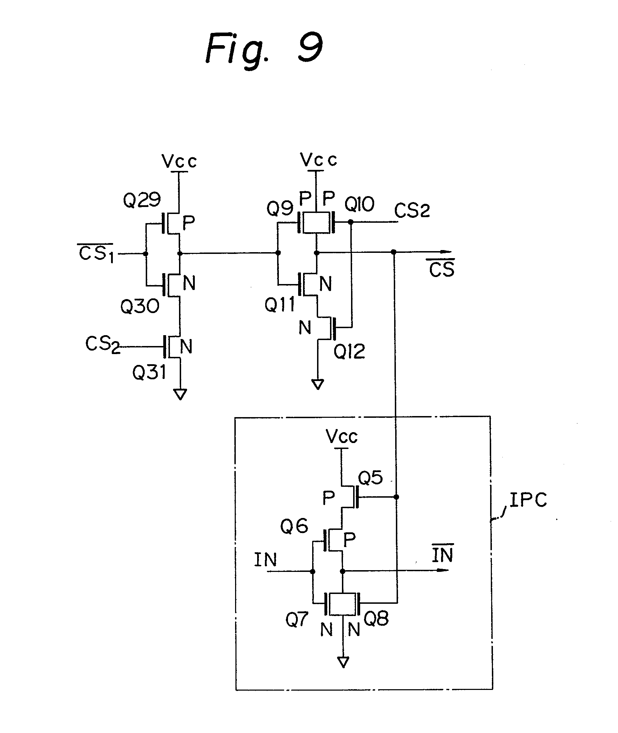

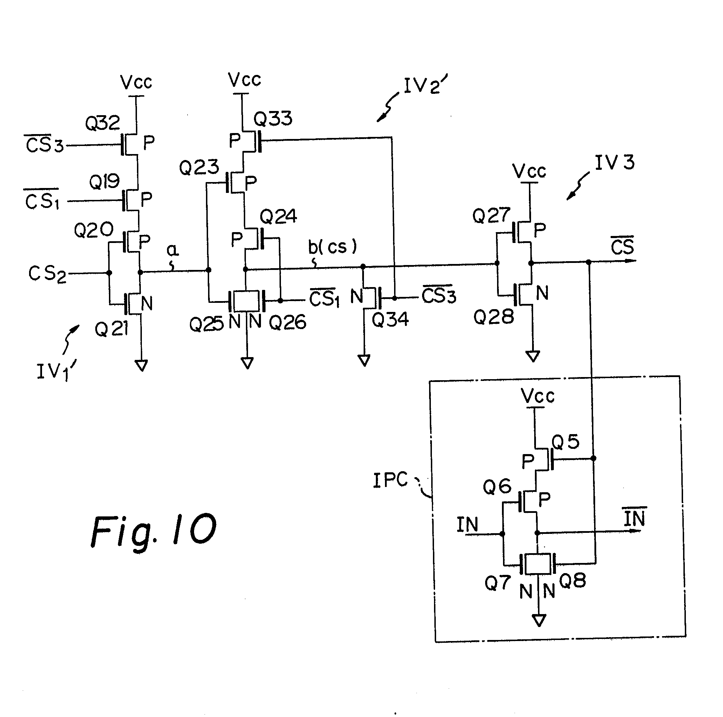

Figures 9 and 10 are partial electrical circuit diagrams illustrating a CMIS circuit device of another embodiment of the present invention.

Before describing the preferred embodiments, some conventional CMIS circuit devices are explained with reference to the drawings.

Figure 1 shows a typical CMIS inverter circuit. The circuit of Fig. 1 is composed of a P-channel metal--insulator semiconductor (MIS) transistor Q1 and an N-channel MIS transistor Q2 which are serially connected between a power source $V_{CC}$, having, for example, a positive voltage, and the ground. Assuming that the threshold voltage of the transistor Q2 is $V_{th}$ (N) and the threshold voltage of the transistor Q1 is $V_{th}$ (P), a direct current flows through the circuit provided that the level $V_{CS}$ of an input signal CS falls within a range represented as $V_{th}$ (N) $\leq V_{CS} \leq V_{CC} - |V_{th}$ (P)$|$. If the level $V_{CS}$ of the input signal CS falls within a range A extending from 0 to $V_{th}$ (N), illustrated in Fig. 2, the transistor Q1 is in an ON state and the transistor Q2 is in a completely OFF state. As a result, the current I becomes zero. As the level $V_{CS}$ is gradually increased from $V_{th}$ (N), the transistor Q2 gradually assumes an ON state so that the current I gradually begins to flow and then gradually increases. When the level $V_{CS}$ reaches a certain intermediate value $V_M$, the current I reaches a peak value because both transistors Q1 and Q2 exhibit a comparatively low-resistance state. As the level $V_{CS}$ is further increased from the intermediate value $V_M$, the N-channel transistor Q2 is saturated deeply whereas the P-channel transistor Q1 gradually assumes a

- 5 -

0107355

non-conductive state. As a result, the current I flowing through the inverter circuit is gradually decreased. If the level $V_{CS}$ falls within a range B, illustrated in Fig. 2, starting from $V_{CC} - |V_{th}(P)|$, the P-channel transistor Q1 is completely turned off so that the current I becomes zero. In general, an input level of a CMIS integrated circuit device is prescribed in a specification as a minimum value $V_{IH}$ of the high--level voltage and a maximum value $V_{IL}$ of the low-level voltage. In an ordinary CMIS integrated circuit device wherein the power source voltage $V_{CC}$ is 5 volts, $V_{IH}$ is 2.0 to 2.4 volts and $V_{IL}$ is approximately 0.8 volts. Such a CMIS integrated circuit device must operate as if a low-level voltage is applied thereto when the input voltage does not exceed $V_{IL}$ and as if a high-level voltage is applied thereto when the input voltage is not lower than $V_{IH}$. As is apparent from Fig. 2, the voltages $V_{IL}$ and $V_{IH}$ thus prescribed exist within a range in which a direct current I shown in Fig. 1 flows. If such a CMIS integrated circuit device is to assume a battery backup condition wherein I = 0, the input voltage must be set at a voltage near 0 volts or $V_{CC}$. However, an integrated circuit device usually has a number of input terminals. In placing an integrated circuit device having multiple input terminals in a battery backup condition, the prior art has a drawback in that all of the multiple input terminals must have a voltage near 0 volts or $V_{CC}$.

Figure 3 shows part of another conventional integrated circuit device in which the drawback of the above-mentioned conventional device has been removed. In the integrated circuit device illustrated in Fig. 3, one or more input circuits IPC to which an input signal IN, such as an address signal or data signal, is applied are controlled by a CMIS inverter for chip selection which is composed of a P-channel transistor Q3 and an N-channel transistor Q4. The input circuit or circuits IPC are composed of a P-channel transistor Q5, a P-channel transistor Q6, and a parallel circuit consisting of an N-channel transistor Q7 and an N-channel transistor Q8 which are serially connected between the power source $V_{CC}$ and the ground. The input signal IN is applied to the gates of the transistors Q6 and Q7. An output signal $\overline{IN}$ is derived from the point where the transistor Q6 and the parallel circuit are coupled and is fed to a circuit within the integrated circuit device. The gates of the transistors Q5 and Q8 are connected to the output of the inverter circuit for chip selection, which circuit outputs the signal $\overline{CS}$.

If the chip-select signal CS, which is the input signal of the inverter for chip selection in the configuration of Fig. 3, is set at 0 volts, the inverted chip-select signal $\overline{CS}$ assumes a level which is approximately $V_{CC}$. Accordingly, the transistor Q5 in the input circuit IPC is turned off and the transistor Q8 is turned on. No matter what state the input signal IN may assume, the inverted input signal $\overline{IN}$ becomes 0 volts. In this case, no direct current flows through any circuit. Even in a multiple-input integrated circuit device, it is possible to attain a battery backup condition by using the circuit illustrated in Fig. 3 and by setting one chip-select signal CS at 0 volts.

On the other hand, when a plurality of memory chips are used in a system such as a computer, it is advantageous in the system configuration for each IC chip to have two chip-select inputs, thereby enabling a battery backup condition to be attained.

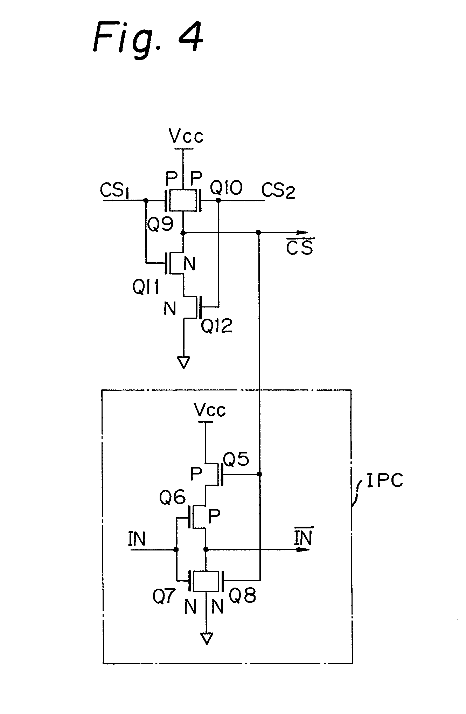

Figure 4 shows part of the configuration of an integrated circuit device wherein, an IC chip thereof can be selected by using two chip-select signals $CS_1$ and $CS_2$. In the circuit illustrated in Fig. 4, a chip-select inverter comprises a parallel circuit composed of P-channel transistors Q9 and Q10, an N-channel transistor Q11, and an N-channel transistor Q12, all of which are connected in series between the power source $V_{CC}$ and the ground. The first chip-select signal $CS_1$ is applied to the gates of the transistor Q9 and the transistor Q11 and the second chip select signal $CS_2$ is applied to the gates of the transistors Q10 and Q12. The inverted internal chip-select signal $\overline{CS}$ for controlling the input circuit IPC, which is the same as the circuit illustrated in Fig. 3, is derived from a point where the parallel circuit composed of transistors Q9 and Q10 is connected to the transistor Q11.

In the circuit illustrated in Fig. 4, it is possible to pull up the inverted chip-select signal $\overline{CS}$ to $V_{CC}$ by setting at least one of the two chip-select signals $CS_1$ and $CS_2$ at 0 volts, thereby attaining a battery backup condition.

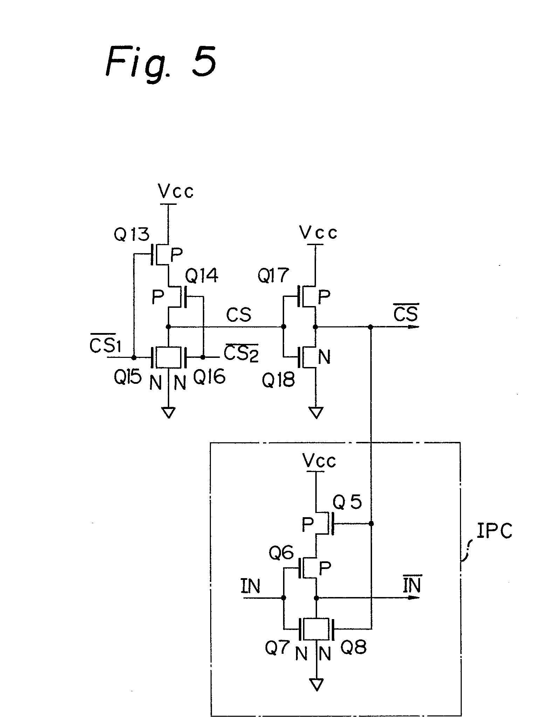

Figure 5 shows part of the configuration of an integrated circuit device wherein an IC chip thereof can be selected by using two inverted select signals $\overline{CS}_1$ and $\overline{CS}_2$. The circuit illustrated in Fig. 5 is equipped with a first inverter, which is composed of a P-channel transistor Q13, a P-channel transistor Q14, and a parallel circuit consisting of N-channel transistors Q15 and Q16 connected in series, and a second inverter which receives the output of the first inverter and is composed of a P-channel transistor Q17 and an N-channel transistor Q18. From the output terminal of the second inverter, an inverted internal chip-select signal $\overline{CS}$ is output to control the input circuit IPC, which is the same as the circuit illustrated in Fig. 3. In this circuit, a battery backup condition can be established by setting at least one of the two inverted chip-select signals $\overline{CS}_1$ and $\overline{CS}_2$ at a level near the power source voltage $V_{CC}$.

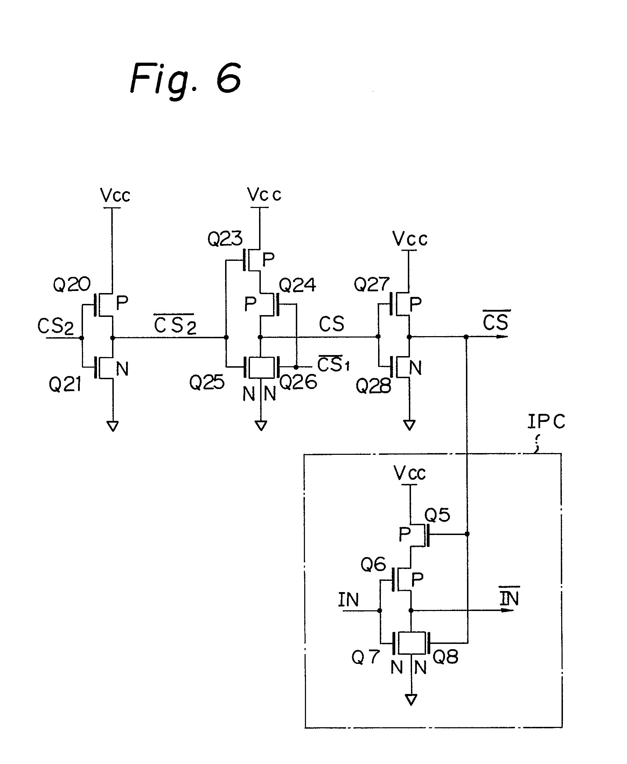

In the integrated circuit devices illustrated in Fig. 4 and Fig. 5, the two chip-select signals must have an identical polarity. Recently, it has been desired, in an integrated circuit device to which two chip-select

- 8 -

0107355

signals having opposite polarities are applied, that a battery backup condition be attained by arbitrarily using one of the two chip-select signals. Accordingly, a circuit configuration as illustrated in Fig. 6 has been proposed. The circuit illustrated in Fig. 6 is equipped with a first inverter composed of a P-channel transistor Q20 and an N-channel transistor Q21, a second inverter composed of P-channel transistors Q23 and Q24 and a parallel circuit consisting of two N-channel transistors Q25 and Q26, and a third inverter composed of a P-channel transistor Q27 and an N-channel transistor Q28. An inverted chip-select signal $\overline{CS}$ for controlling the input circuit IPC, which is the same as the circuit illustrated in Fig. 3, is fed from the output of the third inverter. A chip-select signal $\overline{CS}_1$ is applied to the gates of transistors Q24 and Q26 of the second inverter, and a chip-select signal $CS_2$ is applied to the gates of transistors Q20 and Q21 of the first inverter.

In the circuit illustrated in Fig. 6, the input circuit IPC can be activated and caused to assume a chip-selected state by causing the chip-select signal $\overline{CS}_1$ to assume a low level and by causing the chip-select signal $CS_2$ to assume a high level so that the inverted chip-select signal $\overline{CS}$ assumes a low level. If the chip-select signal $\overline{CS}_1$ is caused to assume a high level or the chip-select signal $CS_2$ is caused to assume a low level, the inverted chip-select signal $\overline{CS}$ is caused to assume a high level and the input circuit IPC is rendered to be in an inactive state. As a result, the inverted input signal $\overline{IN}$ is always at a low level, and a chip--unselected state is attained.

When the chip-select signal $CS_2$ in the circuit of Fig. 6 is caused to assume a low level which is near the ground level, the inverted chip-select signal $\overline{CS}$ can be caused to assume a high level which is near the power source voltage $V_{CC}$. As a result, the current flowing through the input circuit IPC can be decreased to zero. In this case, the N-channel transistor Q21 is turned off in the first inverter. In the second inverter, the P-channel transistor Q23 is turned off irrespective of the state of the chip-select signal $\overline{CS}_1$. In the third inverter, the N-channel transistor Q28 is turned off. Therefore, no current flows through any inverter. A battery backup condition may be completely attained by controlling only the chip-select signal $CS_2$ of the two chip-select signals $\overline{CS}_1$ and $CS_2$. In attempting to attain a battery backup condition by setting the chip--select signal $\overline{CS}_1$ at a high level near the power source voltage $V_{CC}$ , the circuit illustrated in Fig. 6 has a drawback in that the chip-select signal $CS_2$ must be set at a level near the ground level in order to completely reduce to zero the current flowing through the first inverter. That is if chip-select signal $\overline{CS}_1$ is at $V_{CC}$ and the chip-select signal $CS_2$ is at $V_{IL}$ , for example, the N-channel transistor Q21 in the first inverter does not completely turn off. Therefore, a direct current flows through the transistors Q20 and Q21. Accordingly, the circuit illustrated in Fig. 6 has a further drawback in that it is impossible to attain a battery backup condition by controlling only one of the two chip-select signals $\overline{CS}_1$ and $CS_2$ having opposite polarities.

Some embodiments of the present invention are now described with reference to the drawings. Figure 7 shows part of the configuration of a CMIS circuit device which is an embodiment of the present invention. The circuit of Fig. 7 includes a chip-select control circuit for feeding an inverted internal chip-select signal $\overline{CS}$ to an input circuit IPC, which is the same as the circuit illustrated in Fig. 3. The chip-select control circuit comprises three inverter circuits $IV_1$ , $IV_2$ , and $IV_3$.

The first inverter circuit $IV_1$ comprises a P-channel transistor Q19, a P-channel transistor Q20, and an N-channel transistor Q21 which are serially connected between a power source $V_{CC}$ and the ground. A first chip-select signal $\overline{CS}_1$ is applied to the gate of the transistor Q19 and a second chip-select signal $CS_2$ is applied to the gates of the transistors Q20 and Q21. The output of the first inverter $IV_1$ is derived from the point where the transistors Q20 and Q21 are coupled and is fed to the second inverter $IV_2$. In the present embodiment, the second inverter $IV_2$ is practically constructed as a two-input NOR gate circuit. A P-channel transistor Q23, a P-channel transistor Q24, and a parallel circuit composed of an N-channel transistor Q25 and an N-channel transistor Q26 are connected in series between the power source $V_{CC}$ and the ground. The output signal of the first inverter is applied to the gates of the transistors Q23 and Q25. The first chip-select signal $\overline{CS}_1$ is applied to the gates of the transistors Q24 and Q26. The third inverter $IV_3$ comprises a P-channel transistor Q27 and an N-channel transistor Q28 which are connected in series between the power source $V_{CC}$ and the ground.

To the gates of the transistors Q27 and Q28, the output of the second inverter $IV_2$ , i.e., an internal chip-select signal CS, is applied. An inverted internal chip-select signal $\overline{CS}$ is derived from a point where the transistors Q27 and Q28 are coupled and is fed to the input circuit IPC.

Figure 8 shows the circuit status for various levels of the two chip-select signals $\overline{CS}_1$ and $CS_2$. The operation of the circuit illustrated in Fig. 7 is described with reference to Fig. 8. In Fig. 8, L denotes a voltage near zero volts, i.e., a voltage within the region A illustrated in Fig. 2, and H denotes a voltage near the power source voltage $V_{CC}$ , i.e., a voltage within the region B illustrated in Fig. 2. $V_{IL}$

and $V_{IH}$ are, respectively, the same as those illustrated in Fig. 2. For example, $V_{IL}$ is 0.8 volts and $V_{IH}$ is 2.0 to 2.4 volts. To attain a chip-selected state in the circuit illustrated in Fig. 7, the chip-select signal $\overline{CS}_1$ must be at a low level, i.e., L or $V_{IL}$ , and, at the same time, the chip-select signal $CS_2$ must be at a high level, i.e., H or $V_{IH}$. Thereby, the transistors Q19 and Q21 of the first inverter $IV_1$ turn on and the transistor Q20 turns off so that the potential at point a becomes an L level. Accordingly, the transistor Q23 in the second inverter $IV_2$ turns on and the transistor Q25 turns off. Since the transistor Q24 is in a turned-on state and the transistor Q26 is in a turned-off state, the level of the output of the second inverter $IV_2$ , i.e., the level at point b, becomes an H level. Therefore, the output $\overline{CS}$ of the third inverter $IV_3$ assumes a low level. In the input circuit IPC, a transistor Q5 turns on and a transistor Q8 turns off. Therefore, the input circuit IPC functions as an ordinary CMIS inverter and a chip-selected state is attained.

When the chip-select signals $\overline{CS}_1$ and $CS_2$ are not in the above-mentioned states, the inverted chip-select signal $\overline{CS}$ assumes an H level and a chip-unselected state is attained. That is, when both of the chip-select signals $\overline{CS}_1$ and $CS_2$ are at a low level, i.e., at an L or $V_{IL}$ level, both of the transistors Q19 and Q20 in the first inverter $IV_1$ turn on and the level at point a becomes an H level. As a result, the transistor Q25 in the second inverter $IV_2$ turns on and the level at point b becomes an L level. Therefore, the inverted chip-select signal $\overline{CS}$ assumes an H level so that the transistor Q5 in the input circuit IPC turns off and the transistor Q8 turns on. As a result, irrespective of the level of the input signal IN, the inverted input signal $\overline{IN}$ assumes a low level and a chip-unselected state is attained. If, in this case, the chip-select signal $CS_2$ is at an L level, the transistor Q21 in the

first inverter $IV_1$ is completely turned off so that no current $I_1$ flows through the first inverter $IV_1$. Since the level at point a is an H level, the transistor Q23 in the second inverter $IV_2$ is completely turned off and no current $I_2$ flows therethrough. In the third inverter, since the signal at point b, i.e., the input signal, assumes an L level, the transistor Q28 is completely turned off so that no current flows therethrough.

When both chip-select signals $\overline{CS}_1$ and $CS_2$ are at a high level, i.e., H or $V_{IH}$, the transistor Q21 in the first inverter $IV_1$ turns on and the level at point a becomes an L level. Since the transistor Q26 in the second inverter $IV_2$ turns on, the level at point b also becomes an L level. As a result, the inverted chip-select signal $\overline{CS}$ assumes an H level and a chip--unselected state is attained. If, in this case, the chip-select signal $\overline{CS}_1$ is at an H level, both the transistor Q19 in the first inverter $IV_1$ and the transistor Q24 in the second inverter $IV_2$ are completely turned off and no current $I_1 \cdot I_2$ flows through the first and second inverters.

Next, a case where the chip-select signal $\overline{CS}_1$ is at a high level, i.e., H or $V_{IH}$, and the chip-select signal $CS_2$ is at a low level, i.e., L or $V_{IH}$, is considered. If the chip-select signal $\overline{CS}_1$ is at an H level and the chip-select signal $CS_2$ is at an L level, both of the transistors Q19 and Q21 in the first inverter $IV_1$ are completely turned off. Therefore, no current $I_1$ flows through the first inverter $IV_1$ and the output terminal thereof, i.e., point a assumes a floating state. In the second inverter $IV_2$, the transistor Q26 turns on and the transistor Q24 is completely turned off. Therefore, the level at point b becomes an L level and no current $I_2$ flows through the second inverter $IV_2$. When the chip-select signal $\overline{CS}_1$ is $V_{IH}$ and the chip--select signal $CS_2$ is L, the transistor Q21 in the first inverter $IV_1$ is completely turned off. At this time, the transistor Q20 turns on and the transistor Q19 is in a slightly conductive state. As a result, the level at point a becomes an H level, thereby preventing current $I_1$ from flowing through the first inverter $IV_1$. Since, in this case, the transistor Q25 in the second inverter $IV_2$ is turned on, point b assumes an L level and no current $I_2$ flows through the second inverter $IV_2$ because the transistor Q23 is completely turned off. If the chip-select signal $\overline{CS}_1$ is H and the chip-select signal $CS_2$ is $V_{IL}$, the transistor Q19 in the first inverter $IV_1$ turns off, the transistor Q20 turns on, and the transistor Q21 assumes a somewhat conductive state. Therefore, point a assumes an L level, preventing current $I_1$ from flowing through the inverter $IV_1$. In this case, the transistor Q26 in the second inverter $IV_2$ turns on and the transistor Q24 turns off. Accordingly, point b assumes an L level and no current $I_2$ flows through the second inverter $IV_2$. When the chip-select signal $\overline{CS}_1$ is $V_{IH}$ and the chip-select signal $CS_2$ is $V_{IL}$, the transistor Q19 in the first inverter $IV_1$ assumes a somewhat conductive state, the transistor Q20 turns on, and the transistor Q21 assumes a somewhat conductive state. Therefore, point a assumes an intermediate value between the power source voltage $V_{CC}$ and 0 volts. The current $I_1$ flowing through the first inverter $IV_1$ does not assume a zero value. Since, in this case, the transistor Q26 in the second inverter $IV_2$ is turned on, point b assumes an L level. However, the current $I_2$ flowing through the second inverter $IV_2$ is not reduced to zero.

As is evident from the foregoing description, it is possible to attain a chip-unselected state in the circuit illustrated in Fig. 7 by setting the chip-select signal $\overline{CS}_1$ at an H level or the chip-select signal $CS_2$ at an L level. At the same time, it is possible to render the current of both the first and second inverters $IV_1$ and $IV_2$ zero. In such a condition, i.e., the condition indicated by "·" in Fig. 8, point b assumes an L level. Therefore, it is apparent that the value of the current flowing through the third inverter is zero, and a complete battery backup condition is attained.

In the above-mentioned embodiment, the second inverter $IV_2$ is constructed as a NOR gate circuit. That is, the NOR logic output of the inverted chip-select signal $\overline{CS}_1$ and the output signal of the first inverter $IV_1$ is used as the internal chip-select control signal CS.

As is illustrated in Fig. 9, the NOR gate circuit can be replaced with a NAND gate circuit, to which the non-inverted chip-select signal $CS_1$ or $CS_2$ is applied. At this time, the inverted external chip-select signal $\overline{CS}_1$ or $\overline{CS}_2$ is inverted in the first inverter. The output of the first inverter and the remaining chip-select signal $CS_2$ or $CS_1$ are fed to the above-mentioned NAND gate circuit to produce the inverted internal chip-select signal $\overline{CS}$. The feature of the present invention lies in the fact that the remaining chip-select signal $CS_2$ or $CS_1$ is fed to the gate of a transistor which is inserted between a power terminal of the first inverter and a power source. In that modified embodiment, the transistor receiving the chip-select signal $CS_2$ or $CS_1$ may be an N-channel MIS transistor inserted into the first inverter in series with the driver transistor thereof. When at least one of the chip-select signal inputs indicates non-election, the current of the circuits including the first inverter can be made to be substantially zero no matter what level the remaining chip-select signal may assume. Thus, a complete battery backup condition can be realized.

Figure 10 illustrates another modified embodiment showing how the MIS circuit device may be selected by three or more chip-select signals. In this case, the number of transistors Q19 and Q32 inserted into the first inverter is increased in accordance with the number of chip-select signals and the number of logic inputs applied to the second inverter (NOR or NAND gate) is also increased.

In accordance with the present invention, in a CMIS circuit device wherein chip selection is effected by more than two chip-select signals having opposite polarities, it is possible to attain a chip-unselected state and to render the circuit current zero by setting at least one chip-select signal at the unselected                    level, thereby realizing a complete battery backup condition.

## CLAIMS

1. A CMIS circuit device the state of which is controlled by at least two input signals ($\overline{CS}_1$, $CS_2$) and which is made selectable on receiving input signals at least two of which have opposite polarities, the CMIS circuit device having a chip-select control circuit for establishing a chip-selected state and a chip-unselected state in accordance with the received input signals, the chip-select control circuit comprising CMIS inverter means ($IV_1$) for inverting one of the input signals ($CS_2$), and CMIS logic gate means ($IV_2$) for receiving an output signal (a) of the CMIS inverter means ($IV_1$) and the other input signal or signals ($\overline{CS}_I$) and for outputting an internal chip-select control signal (CS), wherein the CMIS inverter means ($IV_1$) comprises a CMIS inverter ($Q_{20}$, $Q_{21}$) and one or more control transistors ($Q_{19}$) receiving the other input signal or signals ($CS_1$) at the gates thereof and which are inserted in series between a power terminal of the CMIS inverter and a power source.

2. A CMIS circuit device according to claim 1, wherein the CMIS logic gate means ($IV_2$) comprises a NOR gate which receives the output signal (a) of the CMIS inverter means ($IV_1$) and the other input signal or signals ($\overline{CS}_1$).

3. A CMIS circuit device according to claim 2, wherein the NOR gate comprises a plurality of

0107355

- 17 -

series-connected transistors $(Q_{23}, Q_{24})$ having a first conductivity type connected in series with a plurality of parallel-connected transistors $(Q_{25}, Q_{26})$ having a second conducitivity type, the gate of one of the series-connected transistors $(Q_{23})$ and the gate of one of the parallel-connected transistors $(Q_{25})$ receiving the output signal (a) of the CMIS inverter means $(IV_1)$, each of the other input signals $(CS_1)$ being fed to gates of a respective pair of the remaining transistors each pair including one of the series-connected transistors $(Q_{24})$ and one of the parallel-connected transistors $(Q_{26})$.

4. A CMIS circuit device according to claim 1, wherein the CMIS logic gate means $(IV_2)$ comprises a NAND gate which receives the output signal (a) of the CMIS inverter means $(IV_1)$ and the other input signal or signals $(\overline{CS_1})$.

5. A CMIS circuit device according to claim 4, wherein the NAND gate comprises a plurality of parallel-connected transistors $(Q_{19}, Q_{10})$ having a first conductivity type connected in series with a plurality of series-connected transistors $(Q_{11}, Q_{12})$ having a second conductivity type, the gate of one of the parallel-connected transistors $(Q_9)$ and the gate of one of the series-connected transistors $(Q_{11})$ receiving the output signal (a) of the CMIS inverter means $(IV_1)$, and the or each of the other input signals $(CS_1)$ being fed to gates of respective pairs of the remaining transistors each pair including one of the parallel-connected transistors $(Q_{10})$ and one of the series-connected transistors $(Q_{12})$.

6. A CMIS circuit device according to any of the preceding claims, wherein the or each control transistor ($Q_{19}$) is connected between a transistor ($Q_{20}$) of the CMIS inverter ($IV_1$) having the same conductivity type as that of the control transistor, and a power source.

7. A CMIS circuit device according to any of the preceding claims, further comprising one or more input circuits (IPC), each of which is controlled by the internal chip-select control signal (CS) and each of which causes an input signal (IN) applied to an internal circuit of the CMIS circuit device to assume a voltage level near the power supply voltage or the ground level.

8. A CMIS circuit device of claim 8, wherein each of the input circuits (IPC) comprises a plurality of series-connected transistors ($Q_5$, $Q_6$) having a first conductivity type connected in series with a plurality of parallel-connected transistors ($Q_7$, $Q_8$) having a second conductivity type, the gate of one of the series-connected transistors ($Q_6$) and the gate of one of the parallel-connected transistors ($Q_7$) receiving an input signal (IN) of the CMIS circuit device and the gate of the other series-connected transistor ($Q_5$) and the gate of the other parallel-connected transistor ($Q_8$) receiving the internal chip-select control signal ($\overline{CS}$) output from the chip-select control circuit.

9. A CMIS circuit device according to any of the preceding claims, wherein the control circuit further comprises additional CMIS inverter means ($IV_3$) for inverting the internal chip select control signal (CS).

## Fig. 1

## Fig. 2

## Fig. 3

# Fig. 4

# Fig. 5

0107355

# Fig. 6

# Fig. 7

6/8

0107355

*Fig. 8*

| $\overline{CS_1}$ | $CS_2$ | $V_a$ | $I_1$ | $V_b$ | $I_2$ |
|---|---|---|---|---|---|
| L | L | H | $= 0$ | L | $= 0$ |
| $V_{IL}$ | L | H | $= 0$ | L | $= 0$ |
| L | $V_{IL}$ | H | $\neq 0$ | L | $= 0$ |
| $V_{IL}$ | $V_{IL}$ | H | $\neq 0$ | L | $= 0$ |
| H | H | L | $= 0$ | L | $= 0$ |
| $V_{IH}$ | H | L | $= 0$ | L | $\neq 0$ |
| H | $V_{IH}$ | L | $= 0$ | L | $= 0$ |
| $V_{IH}$ | $V_{IH}$ | L | $\neq 0$ | L | $\neq 0$ |
| H | L | FLOAT | $= 0$ | L | $= 0$ |
| $V_{IH}$ | L | H | $= 0$ | L | $= 0$ |
| H | $V_{IL}$ | L | $= 0$ | L | $= 0$ |
| $V_{IH}$ | $V_{IL}$ | INTMED | $\neq 0$ | L | $\neq 0$ |
| L | H | L | $= 0$ | H | $= 0$ |
| $V_{IL}$ | H | L | $= 0$ | H | $\neq 0$ |
| L | $V_{IH}$ | L | $\neq 0$ | H | $= 0$ |
| $V_{IL}$ | $V_{IH}$ | L | $\neq 0$ | H | $\neq 0$ |

# Fig. 9

Fig. 10

8/8

0107355